# EUROPEAN PATENT APPLICATION

(11) **EP 2 330 872 A1**
(43) Date of publication of application: **08.06.2011**
(21) Application number: 09014978.2
(22) Date of filing: 03.12.2009
(51) Int. Cl.: H05K 1/02, H05K 1/05

(54) **Light emitting diode substrate and method for producing the same**

(71) Applicant: Chen, Yi-Chang, Xizhi City T'ai pei (TW)
(72) Inventor: Chen, Yi-Chang, Xizhi City T'ai pei (TW)
(74) Representative: Schildberg, Peter

(57) **Abstract**

A method for producing the LED substrate has steps of: providing a conductive metallic board (10), forming multiple grooves (11) in a top (12) of the conductive metallic board (10); protecting the conductive metallic board (10) from corrosion, forming an etched substrate (10a) with circuits and wires for plating on the conductive metallic board, electroless plating the etched substrate (10a) to form an electroless plated substrate (10b), plating an metal layer on the electroless plated substrate (10b), and coating solder mask (90) to obtain the LED substrate (10c). Because LED chips are mounted on the surfaces of the metal layer without insulating adhesive (30) below, heat from LED chips can be dissipated efficiently. The LED substrate (10c) of the present invention can be soldered directly onto a dissipation module to further enhance dissipation efficiency.

## Description

The present invention relates to a method for producing a light emitted diode (LED) substrate, and more particularly to a method for producing an LED substrate without an insulating adhesive between an aluminum substrate and an LED and capable of being soldered to a dissipation module.

Light emitted diode (LED) industry has been developing for many years. To satisfy commercial demand, one LED package has an increased number of LED chips with improved light extraction efficiency. However, heat accumulation from the LED chips is increased and if heat cannot be dissipated from the packages, the LED chips will overheat, which results in "degradation" and shortened life span of the LED chips.

Therefore, the LED package further has an LED substrate allowing the LED chips to be mounted on the substrate. The LED substrate is further attached to a dissipation module, so heat from the LED chips is transmitted to the dissipation module via the LED substrate to avoid heat accumulation in the LED package.

A conventional LED substrate has a metallic board covered with insulating adhesives and multiple metal layers formed on the insulating adhesives. An LED chip is mounted on the LED substrate without contacting the metallic board because insulating adhesives must be mounted between the LED chip and the metallic board. However, the insulating adhesives have poorer thermal-conductivity than metal such that the heat from LED chips still cannot be dissipated efficiently in the conventional LED substrate.

Moreover, when the conventional LED substrate has an aluminum board, although the aluminum board has excellent thermal-conductivity, aluminum oxidizes easily forms an aluminum dioxide (Al₃O₂) layer on surfaces of the aluminum board. When the Al₃O₂ layer is removed from the aluminum board before soldered to the dissipation module with solder (formed substantially from tin), the aluminum board still forms an Al₃O₂ layer at high temperature due to soldering. Therefore, a conventional aluminum board cannot be attached to the dissipation module by soldering.

TW 571413 and TW I228947 disclose that a bottom of an aluminum board is covered with solder paste to connect to a dissipation module. However, the solder paste contains resin with poorer thermal-conductivity than solder. Accordingly, conventional LED substrate cannot dissipate heat efficiently from LED chips.

The primary objective of the present invention is to provide a method for producing an LED substrate without an insulating adhesive between the Al substrate and an LED and capable of being soldered to a dissipation module.

To achieve the objective, the method for producing the LED substrate in accordance with the present invention comprises steps of: providing a conductive metallic board, forming multiple grooves in a top of the conductive metallic board; protecting the conductive metallic board from corrosion, forming an etched substrate with circuits and wires for plating on the conductive metallic board, electroless plating the etched substrate to form an electroless plated substrate, plating metal on the electroless plated substrate, and coating solder mask to obtain the LED substrate.

Because LED chips are mounted on the surfaces of the metal layer without insulating adhesive below, heat from LED chips can be dissipated efficiently. The LED substrate of the present invention can be soldered directly onto a dissipation module to further enhance dissipation efficiency.

### IN THE DRAWINGS

Fig. 1 is a flow chart of a method for producing an LED substrate in accordance with the present invention;
Figs. 2A to 2M are cross sectional side views showing a method of an embodiment for producing an LED substrate in accordance with the present invention;
Figs. 3A to 3M are cross sectional side views showing a method of another embodiment for producing an LED substrate in accordance with the present invention; and
Figs. 4A to 4E are cross sectional side views showing a method for producing a copper plastic board in accordance with the present invention.

The drawings will be described further in connection with the following detailed description. Further, these drawings are not necessarily to scale and are by way of illustration only such that dimensions and geometries can vary from those illustrated.

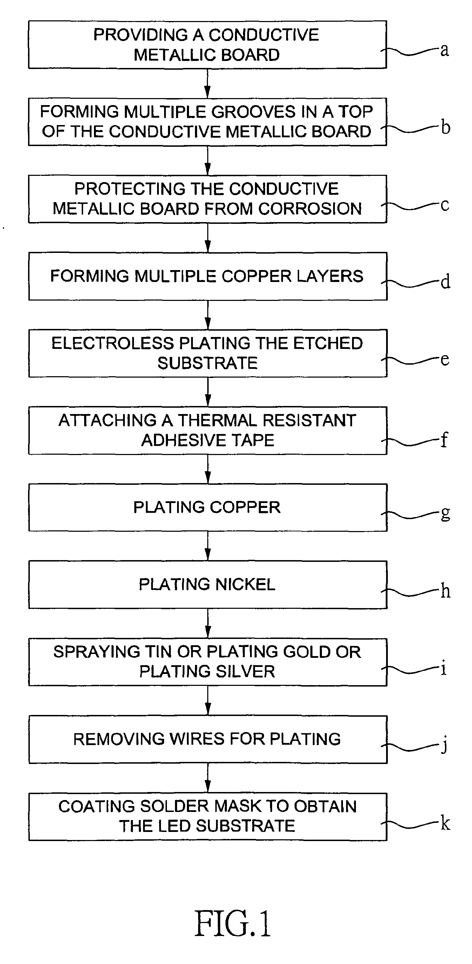

With reference to Figs. 1, 2M and 3M, a method for producing a light emitted diode (LED) substrate in accordance with the present invention comprises steps of: providing a conductive metallic board (10) (a), forming multiple grooves (11) in a top (12) of the conductive metallic board (10) (b) according to a pre-determined pattern; protecting the conductive metallic board (10) from corrosion (c), forming multiple copper layers (40) on the conductive metallic board (10) served as circuits and wires for plating on the conductive metallic board (10) (d), electroless plating the etched substrate (10a) to form an electroless plated substrate (10b) (e), attaching a thermal resistant adhesive tape (51) on a bottom of the electroless plated substrate (10b (f), plating metal on the electroless plated substrate (10b), removing the wires for plating (j), and coating solder mask to obtain the LED substrate (10c) (k).

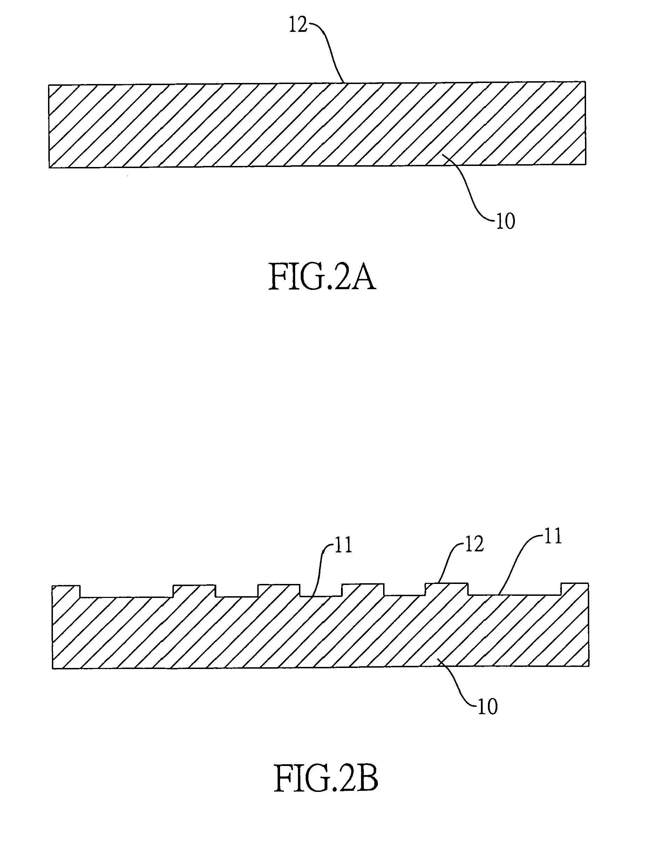

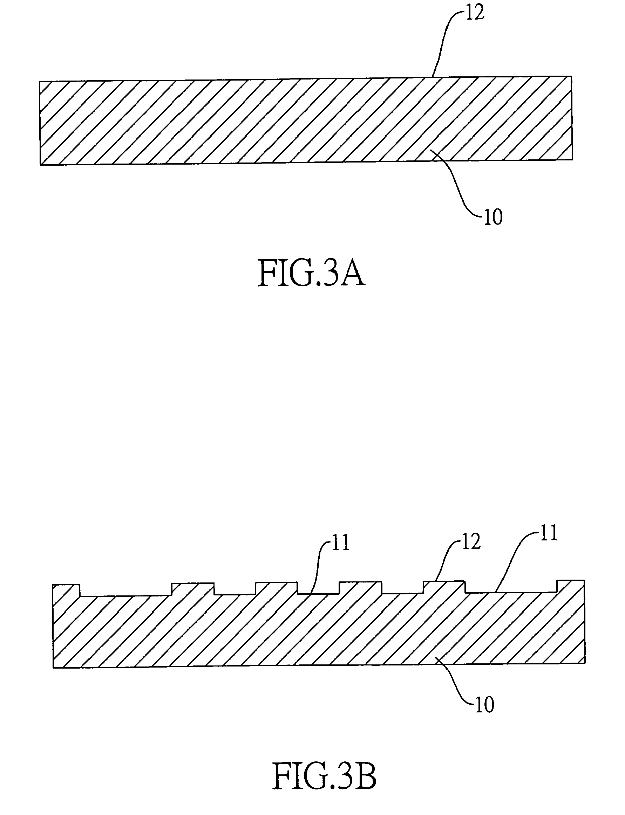

Figs. 2A and 3A show the step of providing a conductive metallic board (10) with a top (12), a bottom and four sides. The conductive metallic board (10) is made of aluminum (Al) or copper (Cu) to form an Al board or a Cu board.

With reference to Figs. 2B and 3B, the step of forming multiple grooves (11) in a top (12) of the conductive metallic board (10) comprises forming multiple grooves (11) in the top (12) of the conductive metallic board (10) according to a pre-determined pattern by etching, die casting, mechanically treating or mold-casting. A depth of each groove is at least 0.05 mm.

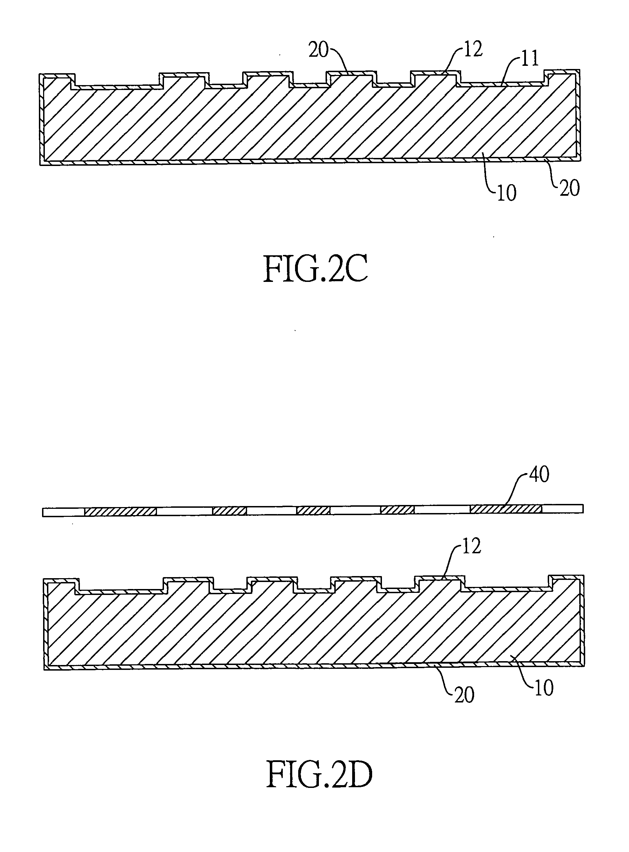

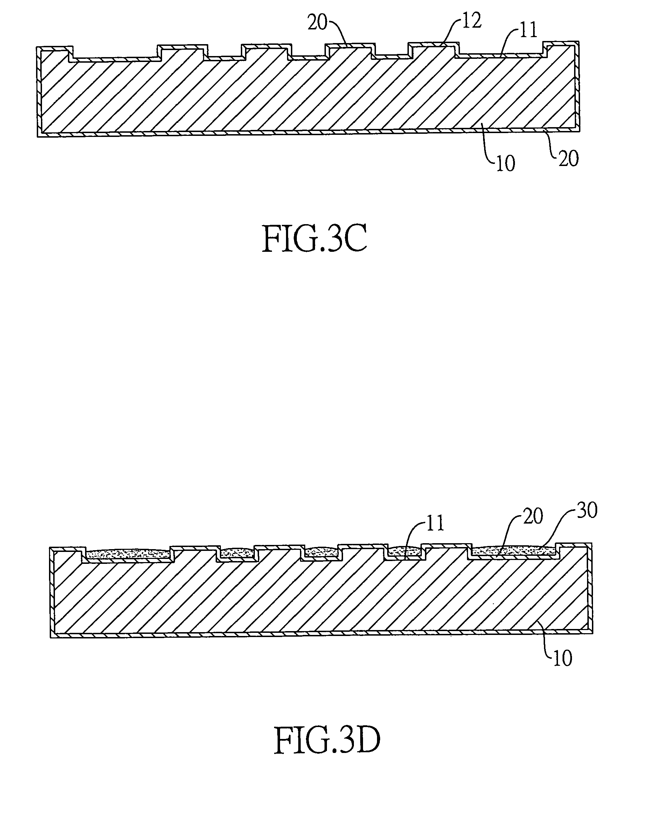

With reference to Figs. 2C and 3C, the step of protecting the conductive metallic board (10) from corrosion comprises conversion coating surfaces of the conductive metallic board (10) with chromate, including trivalent chromium or fluoride to form a conversion coating (20) with a thickness of about 0.1∼1 micrometer (µm).

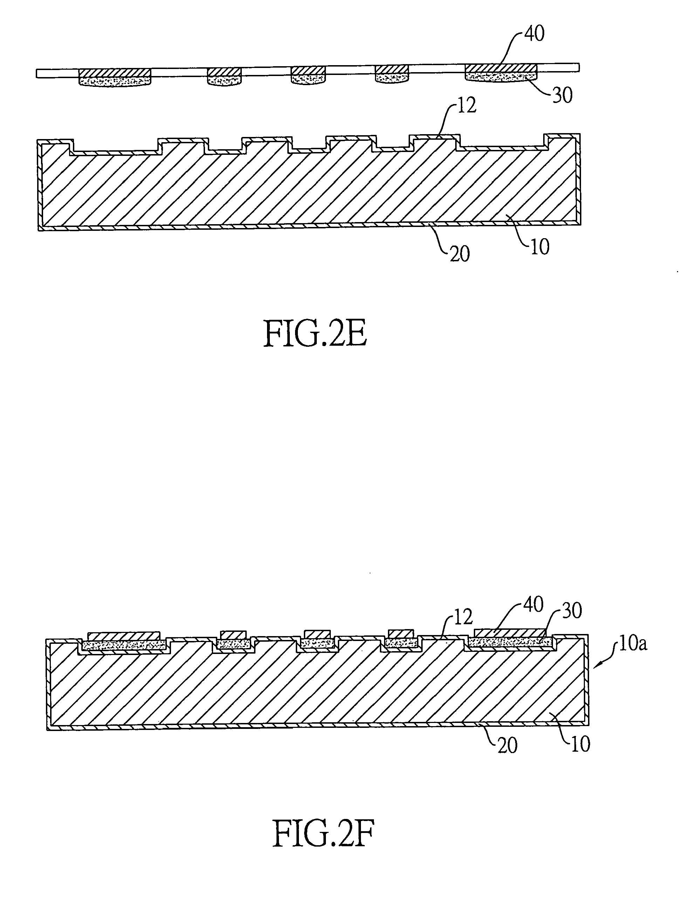

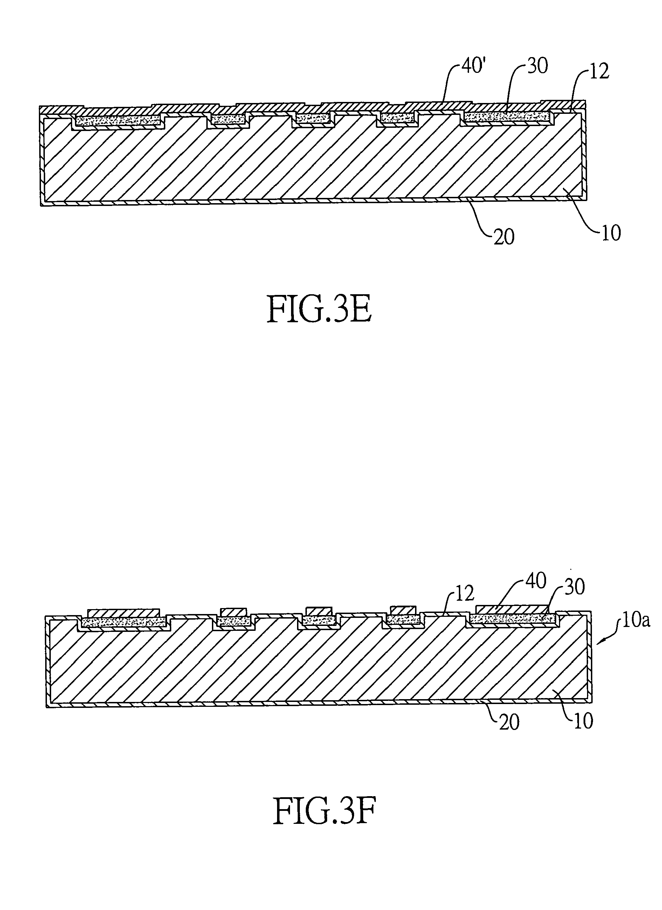

With reference to Figs. 2F and 3F, the step of forming multiple copper layers (40) comprises forming multiple copper layers (40) on the conductive metallic board (10) to be served as circuits and wires for plating and exposing the top (12) of the conductive metallic board (10) with the conversion coating (20) and without contacting the adhesive layers (30) to form an etched substrate (10a). The top (12) of the conductive metallic board (10) with the conversion coating (20) and without contacting the adhesive layers (30) provides locations for coupling with LED chips.

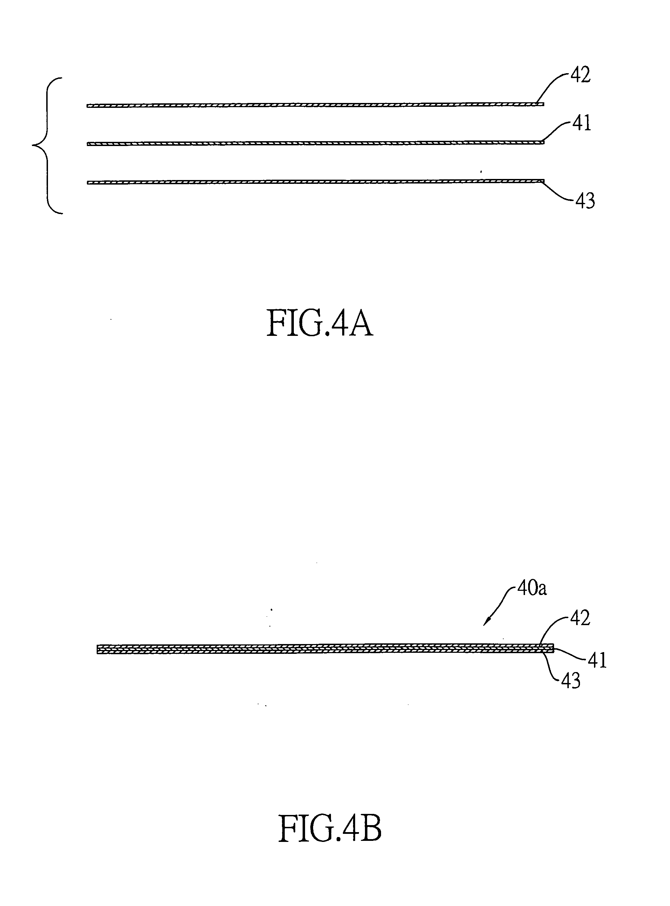

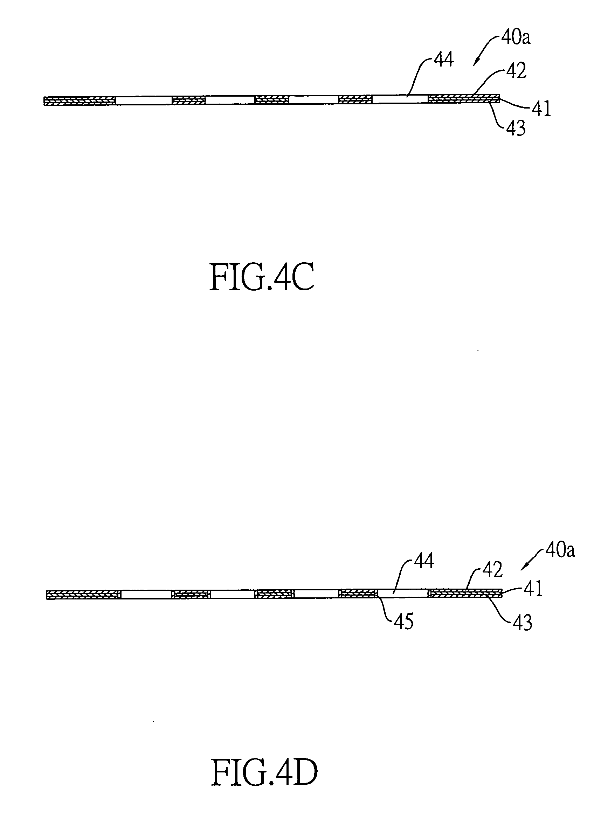

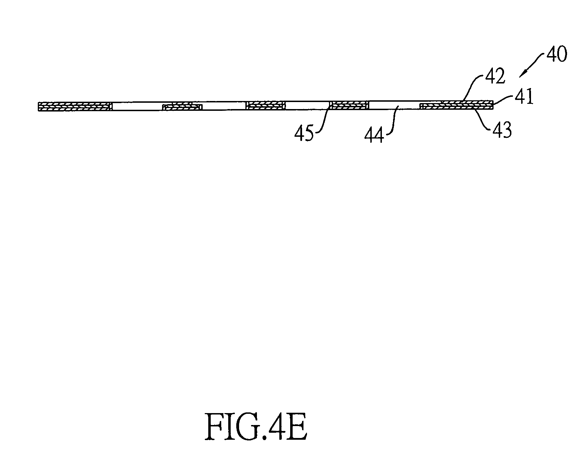

In one embodiment, with reference to Figs. 2D, 2E and 4A to 4E, the step of forming multiple copper layers (40) with circuits and wires for plating comprises providing a high-temperature endurable engineering flexible plastic board (41), an upper copper foil (42) and a lower copper foil (43) (Fig. 4A); respectively pressing the upper and lower copper foils (42, 43) to an upper surface and a lower surface of the flexible plastic board (41) to form a copper plastic board (40a) (Fig. 4B), wherein the upper and lower copper foils (42, 43) are served as two electrodes; mechanically processing the copper plastic board (40a) to form multiple through holes (44) in the copper plastic board (40a) according to the pre-determined pattern (Fig. 4C); optionally etching the copper plastic board (40a) to form multiple drilled holes according to circuits; etching the upper and lower copper foils (42, 43) to form pretreated circuits and wires for plating; immersing the copper plastic board (40a) into a copper sulfate (CuSO₄) solution to plate the copper plastic board (40a) to form plated layers (45) with a thickness of 10∼15 µm on surfaces of the upper and lower copper foils (42, 43) and inner walls of the through holes (44) to communicate with the upper and lower copper foils (42, 43) (Fig. 4D, only the plated layers (45) on the inner walls of the through holes (44) are shown); etching the copper plastic board (40a) to form circuits and wires for plating (Fig. 4E) and avoid the upper and lower copper foils (42, 43) to communicate with each other to result in short; screen-printing insulating adhesives on the lower copper foils (42) of the copper plastic board (40a) (Fig. 2E); pressing the copper plastic board (40a) on the conductive metallic board (10) at 150∼200 °C for 30-50 minutes to form multiple copper layers (40) and multiple adhesive layers (30), such that the lower copper foil (43) connects firmly with the conductive metallic board (10); exposing the top (12) of the conductive metallic board (10) covered with the conversion coating (20) to form an etched substrate (10a) with copper layers (40) served as circuits and wires for plating (Fig. 2F).

The LED chips bond all wires on the upper copper foil (42) while some wires on the upper copper foil (42) can be served as one electrode and other wire on the upper copper foil (42) communicating with the lower copper foil (43) by the through holes (44) to be served as another electrode.

In another embodiment, with reference to Figs. 3D and 3E, the step of forming multiple copper layers (40) with circuits and wires for plating comprises screen-printing insulating adhesives on the conversion coatings (20) in the grooves (11) of the conductive metallic board (10) to form multiple adhesive layers (30); and pressing a copper foil (40') onto the adhesive layers (30) under 150∼200°C for 30-50 minutes; etching the copper foil (40') without connecting to the adhesive layers (30) according to the pre-determined pattern to form an etched substrate (10a) with copper layers (40) served as circuits and wires for plating and partially exposing the top (12) of the conductive metallic board (10) with the conversion coating (20).

Each adhesive layer (30) is made of phenyl novolac epoxy and has a thickness of less than 0.05 mm, so that the insulating adhesives will not flow to the top (12) of the conductive metallic board (10) to communicate with each other after being heated.

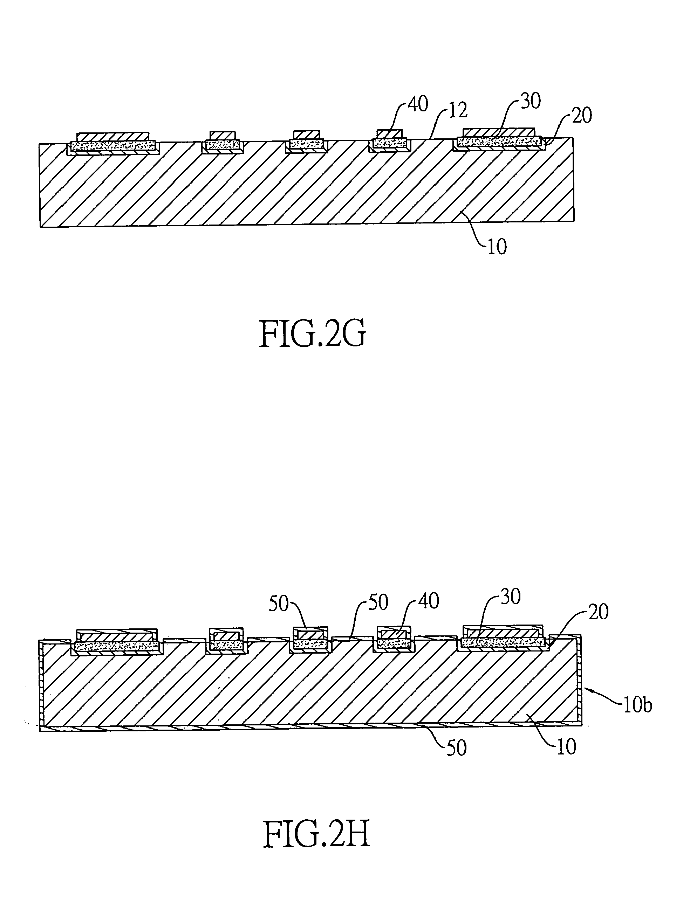

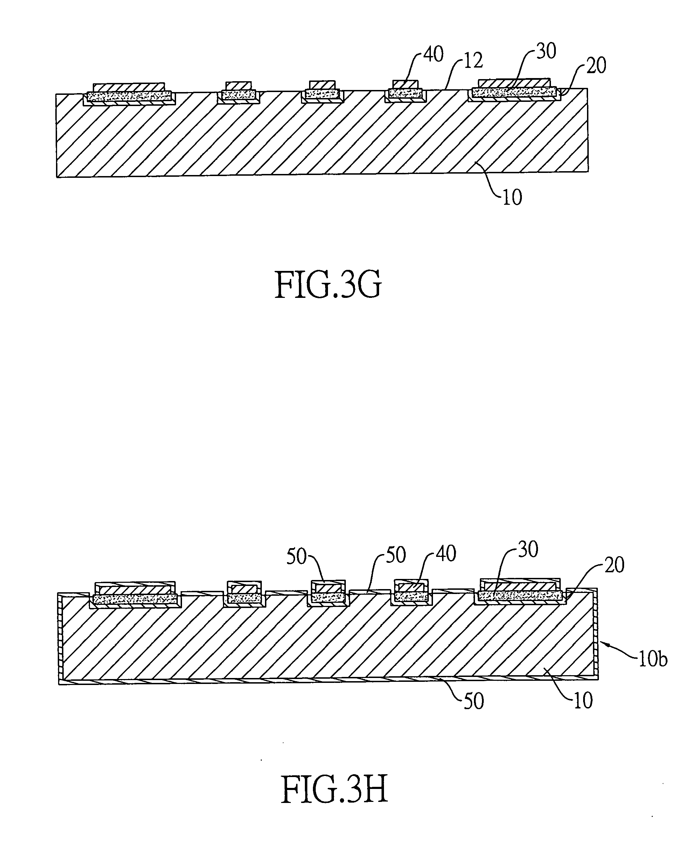

With reference to Figs. 2G and 3G, the step of electroless plating the etched substrate (10a) comprises pretreating the etched substrate (10a) by partially removing conversion coating (20) without contacting the insulating adhesives from the conductive metallic board (10) by acid wash to partially expose the top (12), sides and bottom of the conductive metallic board (10), then with reference to Fig. 2H and 3H, immersing the etched substrate (10a) into an electroless nickel plating bath and electroless plating all exposing metal of the etched substrate (10a) to form an electroless plated substrate (10b) with electroless nickel (Ni) layers (50). The electroless Ni layer (50) has a thickness of 3-5 µm.

When the conductive metallic board (10) is the Al board, the Al board is electroless plated by zinc (Zn) replacement and the copper layer (40) is electroless plated by contact plating via the wires for plating.

When the conductive metallic board (10) is the Cu board, the Cu board and the copper layer (40) are electroless plated by contact plating via the wires for plating.

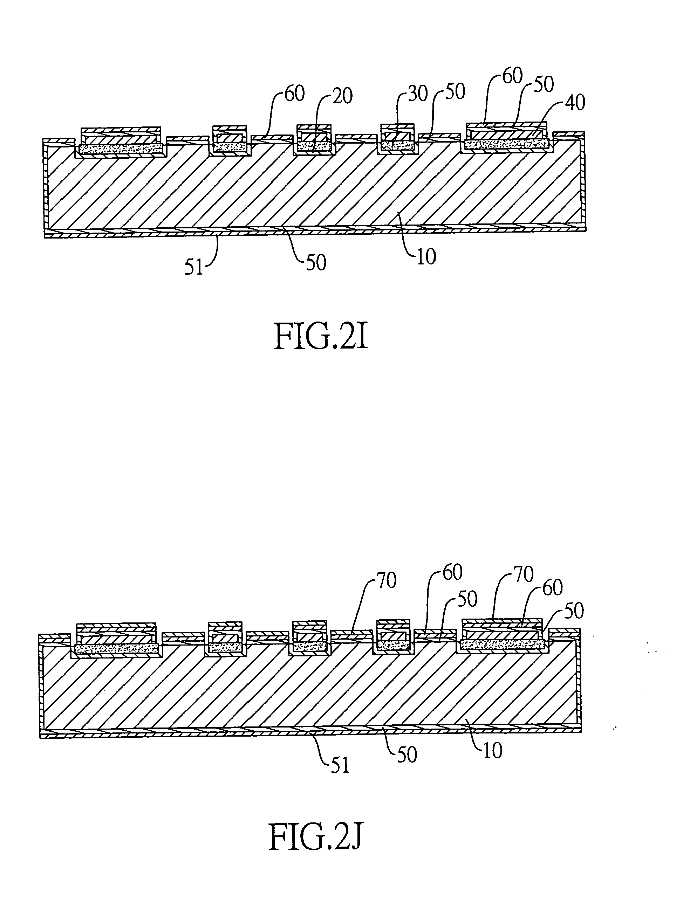

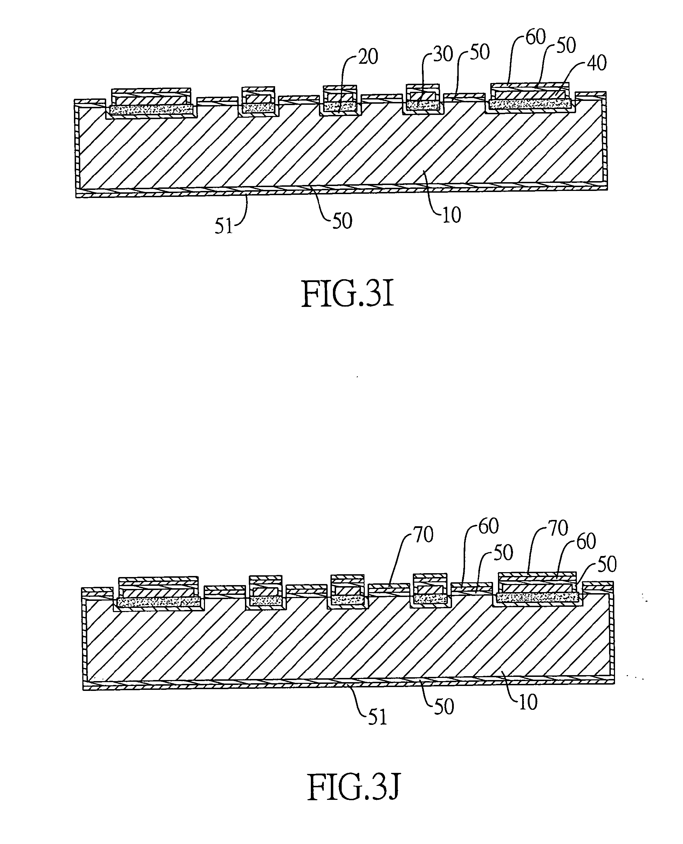

With reference to Figs. 2I and 3I, the step of attaching a thermal resistant adhesive tape (51) on a bottom of the electroless plated substrate (10b) prevents other metal from being plated on the bottom of the electroless plated substrate (10b) to reduce costs.

The step of plating metal on the electroless plated substrate (10b) at least comprises a step of spraying tin or plating gold or plating silver on a top of the electroless plated substrate (10b) to form a tin layer, gold layer or silver layer (80).

In a more detailed embodiment, with reference to Figs. 1, 2I, 3I, 2J, 3J and 2K and 3K, the step of plating metal on the electroless plated substrate (10b) comprises steps of plating copper (Cu) (h), plating nickel (Ni) (i) and spraying tin, plating gold or plating silver (j).

With reference to Figs. 2I and 3I, the step of plating copper (Cu) comprises plating Cu on the electroless Ni layer (50) on a top of the electroless plated substrate (10b) to form a plated Cu layer (60) with a thickness of 10∼15 µm.

With reference to Figs. 2J and 3J, the step of plating nickel (Ni) comprises plating Ni on the plated Cu layer (60) to form a plated Ni layer (70) with a thickness of 3-5 µm.

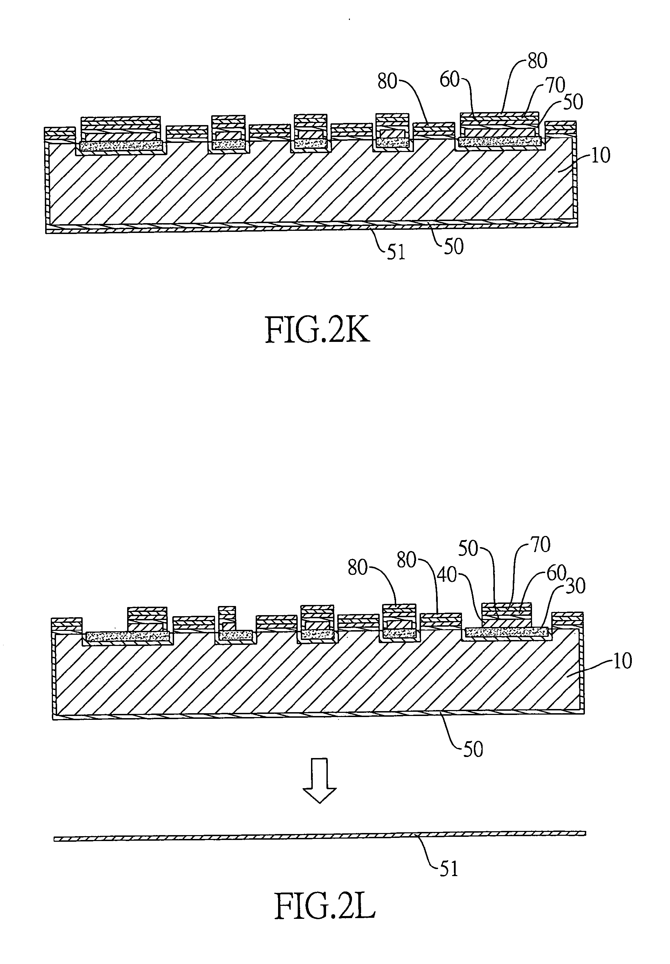

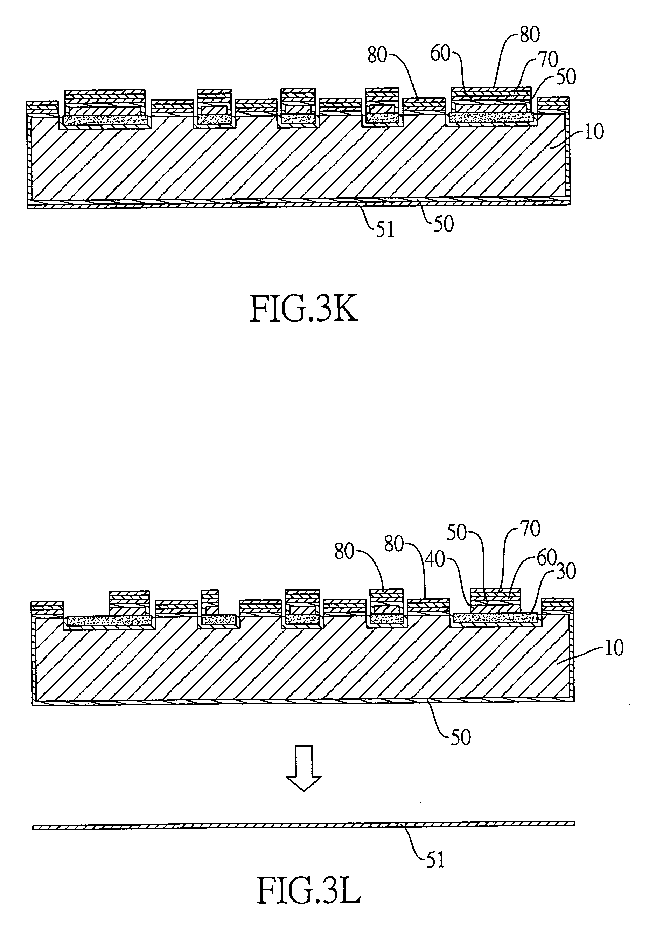

With reference to Figs. 2K and 3K, the step of spraying tin, plating gold or plating silver comprises spraying tin, plating gold or plating silver on the plated Ni layer (70) to form a tin layer or gold layer or silver layer (80).

With reference to Figs. 2L and 3L, the step of removing the wires for plating comprises removing the wires including part of electroless Ni layers (50), the plated Cu layer (60), the plated Ni layer (70) and the tin layer or gold layer or silver layer (80) and removing the thermal resistant adhesive tape (51) from the bottom of the electroless plated substrate (10b).

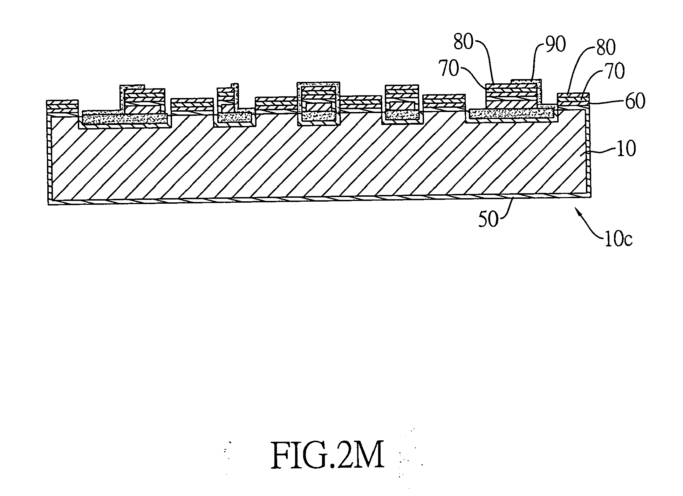

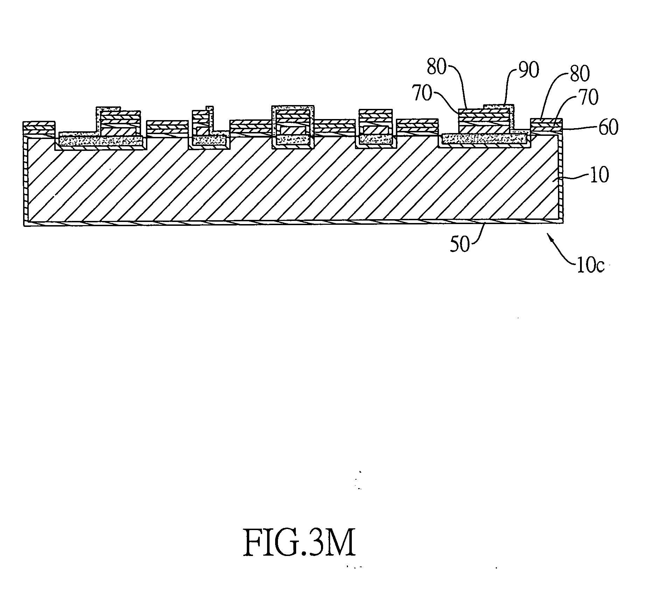

With reference to Figs. 2M and 3M, the step of coating solder mask comprises coating solder mask partially on the metal using screen-printing to form a solder mask layer (90) to expose surfaces of the metal layer without copper layer (40) below for attaching LED chips and with copper layer (40) below for bonding wires to obtain the LED substrate (10c).

When the method of the present invention is performed, a plate including a plurality of LED substrates (10c) is integrally processed. After the step of coating solder mask, the plate is cut into multiple individual LED substrates (10c) with desired shapes.

A light emitted diode (LED) substrate (10c) in accordance with the present invention is made by the foregoing method.

With reference to Figs. 2M and 3M, a light emitted diode (LED) substrate (10c) in accordance with the present invention comprises a conductive metallic board (10), multiple copper layers (40), multiple electroless Ni layers (50), multiple metal layers and a solder mask layer (90).

The conductive metallic board (10) has a top (12), a bottom, multiple grooves (11), multiple conversion coatings (20) and multiple adhesive layers (30). The conductive metallic board (10) may be an aluminum (Al) board or a copper (Cu) board. The grooves (11) are formed in the top (12) of the conductive metallic board (10) according to a pre-determined pattern and has a thickness of at least 0.05 mm. The conversion coatings (20) are formed in the grooves (11), are made of trivalent chromium or fluoride and individually have a thickness of 0.1∼1 µm. The adhesive layers (30) are made of phenyl novolac epoxy, are formed on the conversion coatings (20) in the grooves (11) and individually has a thickness of less than 0.05 mm.

The copper layers (40) are formed on the adhesive layers (30).

In one embodiment, with reference to Fig. 4E, each copper layer (40) comprises a flexible plastic board (41), an upper copper foil (42), a lower copper foil (43), multiple through holes (44) and multiple plated layers (45). The flexible plastic board (41) has an upper surface and a lower surface. The upper copper foil (42) is pressed on the upper surface of the flexible plastic board (41). The lower copper foil (43) is pressed on the lower surface of the flexible plastic board (41). The through holes (44) is formed in the copper layer (40) through the upper copper foil (42), the flexible plastic board (41) and the lower copper foil (43) and each through hole (44) has an inner wall. The plated layers (45) are plated on the inner walls of the through holes (44) to electrically communicate with the upper copper foil (42) and the lower copper foil (43).

In another embodiment, with reference to Fig. 3E, each copper layer (40) is made of a copper foil.

The electroless Ni layers (50) are electroless plated over the copper layers (40) and the conductive metallic board (10) without being covered by the conversion coatings (20) and the adhesive layers (30).

The metal layers are mounted on the electroless Ni layers (50) above the top (12) of the conductive metallic board (10) and each metal layer at least comprises a tin layer or gold layer or silver layer (80) formed on the electroless Ni layers (50). Preferably, each metal layer comprises a plated Cu layer (60), a plated Ni layer (70) and a tin layer or gold layer or silver layer (80). The plated Cu layer (60) is plated on the electroless Ni layers (50) above the top (12) of the Conductive metallic board (10). The plated Ni layer (70) is plated on the plated Cu layer (60). The tin layer or gold layer or silver layer (80) is formed on the plated Ni layer (70).

The solder mask layer (90) is partially applied on the metal layer to expose surfaces of the metal layer without copper layer (40) below for attaching LED chips and with copper layer (40) below for bonding wires.

Because LED chips are mounted on the surfaces of the metal layer without insulating adhesive below, heat generated from the LED chips is transmitted to the conductive metallic board (10) via metal conduction, including metal layer and the electroless Ni layer (50) rather than insulating adhesives. Therefore, the heat from LED chips can be dissipated efficiently, which avoids degradation of LED chips.

Moreover, the bottom of the conductive metallic board (10), especially the Al board, is electroless plated with the electroless Ni layer, so the conductive metallic board (10) can be soldered directly onto a dissipation module. Because the electroless Ni layer and solder are metal, heat from the conductive metallic board (10) is transmitted efficiently to the dissipation module. The present invention has a dissipation rate over 30% higher than a conventional LED substrate.

## Claims

1. A method for producing a light emitted diode (LED) substrate comprising steps of:
providing a conductive metallic board (10) (a) with a top (12), a bottom and four sides and the conductive metallic board (10) is made of aluminum (Al) or copper (Cu);
forming multiple grooves (11) in the top (12) of the conductive metallic board (10) (b);
protecting the conductive metallic board (10) from corrosion to form a conversion coating (20) (c);
forming multiple copper layers (40) having forming multiple copper layers (40) on the conductive metallic board (10) to be served as circuits and wires for plating to form an etched substrate (10a);
electroless plating the etched substrate (10a) including pretreating the etched substrate (10a) and immersing the etched substrate (10a) into an electroless nickel (Ni) plating bath and electroless plating all exposing metal of the etched substrate (10a) to form an electroless plated substrate (10b) (e) with electroless Ni layers;
attaching a thermal resistant adhesive tape (51) on a bottom of the electroless plated substrate (10b) (f);
plating metal on the electroless plated substrate (10b) at least having a step of spraying tin or plating gold or plating silver on a top of the electroless plated substrate (10b); and
coating solder mask partially on the metal to obtain the LED substrate (10c) (k).

2. The method as claimed in claim 1, wherein the step of forming multiple copper layers has
providing a flexible plastic board (41), an upper copper foil (42) and a lower copper foil (43);
respectively pressing the upper and lower copper foils (42, 43) to an upper surface and a lower surface of the flexible plastic board (41) to form a copper plastic board (40a), wherein the upper and lower copper foils (42, 43) are served as two electrodes;
mechanically processing the copper plastic board (40a) to form multiple through holes (44) in the copper plastic board d (40a) according to the pre-determined pattern;
etching the upper and lower copper foils (42, 43) to form pretreated circuits and wires for plating;
immersing the copper plastic board (40a) into a copper sulphate (CuSO₄) solution to plate the copper plastic board (40a) to form plated layers (45) with a thickness of 10∼15 µm on surfaces of the upper and lower copper foils (42, 43) and inner walls of the through holes (44) to communicate with the upper and lower copper foils (42, 43);
etching the copper plastic board (40a) to form circuits and wires for plating;
screen-printing insulating adhesives on the lower copper foils (42) of the copper plastic board (40a);
pressing the copper plastic board (40a) on the conductive metallic board (10) at 150∼200 °C for 30∼50 minutes to form multiple copper layers (40) and multiple adhesive layers (30);
exposing the top (12) of the conductive metallic board (10) covered with the conversion coating (20) to form an etched substrate (10a) with copper layers (40) served as circuits and wires for plating and exposing the top (12) of the conductive metallic board (10) (d) with the conversion coating (20) and without contacting the adhesive layers (30).

3. The method as claimed in claim 1, wherein the step of forming multiple copper layers (40) has
screen-printing insulating adhesives on the conversion coatings (20) in the grooves (11) of the conductive metallic board (10) to form multiple adhesive layers (30);
pressing a copper foil (40') onto the adhesive layers (30) under 150∼200°C for 30-50 minutes;
etching the copper foil (40') without connecting the adhesive layers (30) according to the pre-determined pattern to form an etched substrate (10a) with copper layers (40) served as circuits and wires for plating and exposing the top (12) of the conductive metallic board (10) with the conversion coating (20) and without contacting the adhesive layers (30).

4. The method as claimed in claim 2, wherein the adhesive layer (30) is made of phenyl novolac epoxy and has a thickness of less than 0.05 mm.

5. The method as claimed in claim 3, wherein the adhesive layer (30) is made of phenyl novolac epoxy and has a thickness of less than 0.05 mm.

6. The method as claimed in any one of claims 1 to 6, wherein the step of protecting the conductive metallic board (10) from corrosion comprises conversion coating the top (12), the bottom and the sides of the conductive metallic board (10) with fluoride or chromate including trivalent chromium to form a conversion coating (20) with a thickness of about 0.1∼1 micrometer (µm).

7. The method as claimed in any one of claims 1 to 6, wherein when the conductive metallic board (10) is made ofAl, the step of electroless plating the etched substrate (10a) comprises immersing the etched substrate (10a) into an electroless nickel plating bath, wherein the conductive metallic board (10) is electroless plated by zinc (Zn) replacement and the copper layer (40) is electroless plated by contact plating via the wires for plating.

8. The method as claimed in any one of claims 1 to 6, wherein when the conductive metallic board is made of Cu, the step of electroless plating the etched substrate (10a) comprises immersing the etched substrate (10a) into an electroless nickel plating bath, wherein the conductive metallic board (10) and the copper layer (40) are electroless plated by contact plating via the wires for plating.

9. The method as claimed in any one of claims 1 to 6, wherein the step of plating metal on the electroless plated substrate (10b) further has steps of:
plating copper (Cu) (h) comprises plating Cu on the electroless Ni layer (50);
plating nickel (Ni) (i) comprises plating Ni on the plated Cu layer (60) to form a plated Ni layer (70); and
the step of spraying tin, plating gold or plating silver (j) comprises spraying tin, plating gold or plating silver on the plated Ni layer (70).

10. A light emitted diode (LED) substrate, comprising:
a conductive metallic board (10) being made of A1 or Cu and having
a top (12);
a bottom;
multiple grooves (11) formed in the top (12) of the conductive metallic board (10) according to a pre-determined pattern; and
multiple adhesive layers (30) formed in the grooves (11) in the conductive metallic board (10);
multiple copper layers (40) formed on the adhesive layers (30);
multiple electroless Ni layers (50) electroless plated over the copper layers (40) and the top (12) of the conductive metallic board (10) without covered by the adhesive layers (30);
multiple metal layers mounted on the electroless Ni layers (50) above the top (12) of the conductive metallic board (10) and each metal layer at least having a tin layer or gold layer or silver layer (80); and
a solder mask layer (90) partially applied on the metal layer to expose surfaces of the metal layer without copper layer (40) below adapted for attaching LED chips and with copper layer (40) below adapted for bonding wires.

11. The LED substrate as claimed in claim 10, wherein each copper layer (40) comprises
a flexible plastic board(41) having an upper surface and a lower surface; an upper copper foil (42) pressed on the upper surface of the flexible plastic board (41);
a lower copper foil (43) pressed on the lower surface of the flexible plastic board (41);
multiple through holes (44) formed in the copper layer (40) through the upper copper foil (42), the flexible plastic board (41) and the lower copper foil (43) and each through hole (44) having an inner wall; and
multiple plated layers (45) plated on the inner walls of the through holes (44) to electrically communicate with the upper copper foil (42) and the lower copper foil (43).

12. The LED.substrate as claimed in claim 10, wherein each copper layer (40) is made of a copper foil.

13. The LED substrate as claimed in any one of claims 10 to 12, wherein each groove (11) has a thickness of at least 0.05 mm; and
each adhesive layer (30) is made of phenyl novolac epoxy and has a thickness of less than 0.05 mm.

14. The LED substrate as claimed in any one of claims 10 to 12, wherein the metal layer further has
a plated copper layer (60) formed between the electroless Ni layer (50) and the tin layer or gold layer or silver layer (80); and
a plated Ni layer (70) formed between the plated copper layer (60) and the tin layer or gold layer or silver layer (80).

15. The LED substrate as claimed in any one of claims 10 to 12, wherein the conductive metallic board (10) further has multiple conversion coatings (20) formed in the grooves (11), formed between the conductive metallic board (10) and the adhesive layers (30), are made of trivalent chromium or fluoride and individually have a thickness of 0.1∼1 µm.
